# DEMANDE DE BREVET EUROPEEN

(11) **EP 4 762 981 A1**
(43) Date de publication de la demande: **24.06.2026**
(21) Numéro de dépôt: 24222587.8
(22) Date de dépôt: 20.12.2024
(51) Int. Cl.: A44C 27/00, C23C 14/00, G02B 5/28, G04B 19/12, G04B 37/22, G04B 45/00

(54) **COMPOSANT D'HABILLAGE COMPRENANT UN EMPILEMENT DE COUCHES INTERFÉRENTIELLES DÉPOSÉ SUR UNE FACE RÉALISÉE DANS UN MATÉRIAU COMPRENANT AU MOINS 50% EN MASSE D'ALUMINIUM**

(71) Demandeur: The Swatch Group Research and Development Ltd, 2074 Marin (CH)
(72) Inventeur: HALLER, Camille, 1400 Yverdon-les-Bains (CH); CURCHOD, Loïc, 1004 Lausanne (CH); BAUDOZ, Marie, 25500 Morteau (CH); POLY, Giovanni, 25140 Charquemont (FR)
(74) Mandataire: ICB SA

(57) **Abrégé**

L'invention concerne un composant d'habillage (10) d'horlogerie, de bijouterie ou de joaillerie, caractérisé en ce qu'il comprend un substrat (100) présentant une face support (101) réalisée dans un matériau au moins 50% en masse d'aluminium, sur laquelle est déposé un empilement de couches minces diélectriques (110) semi-transparentes comprenant au moins deux couches, dont une couche de base (111) réalisée en Al₂O₃ reposant sur la face support (101), et une couche terminale (112) réalisée en TiO₂.

## Description

### Domaine technique de l'invention

L'invention relève du domaine de l'horlogerie, de la bijouterie ou de la joaillerie, et concerne plus particulièrement un composant d'habillage d'horlogerie, de bijouterie ou de joaillerie.

Dans le présent texte, les termes « composant d'habillage » désignent, de façon communément admise dans les domaines précités, un composant visible pour un utilisateur, et ayant une fonction notamment décorative, c'est-à-dire contribuant à l'aspect visuel d'un objet.

### Arrière-plan technologique

Dans les domaines de l'horlogerie, de la bijouterie et de la joaillerie, les acteurs économiques sont constamment à la recherche de nouvelles solutions de décoration pour modifier l'apparence de leurs produits afin d'en augmenter l'attractivité ou afin de se distinguer de la concurrence.

Par exemple, dans le domaine de l'horlogerie en particulier, il est connu de colorer des composants d'habillage par le dépôt, sur un substrat, de couches minces par des méthodes de dépôt sous vide, par exemple par dépôt physique en phase vapeur ou par dépôt chimique en phase vapeur. Cependant, selon la nature du substrat et des couches déposées, il est possible de rencontrer des problèmes d'accroche. Cet inconvénient nécessite de déposer une couche d'accroche, ce qui participe à complexifier le procédé de coloration du composant.

En ce qui concerne en particulier les composants d'habillage comprenant un substrat réalisé en aluminium, il est possible de résoudre l'inconvénient précité par la mise en oeuvre d'un procédé d'anodisation du substrat afin de colorer le composant d'habillage. Cependant, le procédé d'anodisation est relativement long à réaliser dans la mesure où il nécessite des temps de cycle conséquents pour faire croitre une couche d'oxyde sur le substrat et qu'il implique la réalisation d'une multitude d'étapes. Par ailleurs, entre chaque étape, les composants d'habillage doivent être manipulés, ce qui augmente le risque d'endommagement de ces derniers.

### Résumé de l'invention

L'invention résout les inconvénients précités et concerne, à cet effet, un composant d'habillage d'horlogerie, de bijouterie ou de joaillerie, caractérisé en ce qu'il comprend un substrat présentant une face support réalisée dans un matériau comprenant au moins 50% en masse d'aluminium, sur laquelle est déposé un empilement de couches minces diélectriques comprenant au moins deux couches, dont une couche de base réalisée en Al₂O₃ reposant sur la face support, et une couche terminale réalisée en TiO₂.

L'invention permet avantageusement de garantir une excellente adhérence entre la face support et l'empilement de couches minces diélectriques du fait de l'affinité chimique entre ladite face et la couche de base. L'empilement de couches permet en outre de conférer une couleur vive et précise au composant d'habillage.

Par ailleurs, la présente invention constitue avantageusement une alternative à la coloration d'un substrat en aluminium par anodisation sans en présenter les inconvénients. En effet, les couches de l'empilement de couches minces diélectriques sont déposées par une méthode de dépôt de couches minces atomiques connue par l'homme du métier sous l'acronyme « ALD » en langue anglaise pour « Atomic Layer Déposition », ce qui permet de colorer rapidement et simplement un substrat en aluminium, sans qu'il soit nécessaire de manipuler le composant d'habillage entre le dépôt de chaque couche.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, le composant d'habillage comprend un nombre pair de couches intermédiaires, et au moins deux, lesdites couches intermédiaires étant déposées entre la couche de base et la couche terminale et étant alternativement réalisée en TiO₂ et en Al₂O₃ de sorte que la couche intermédiaire reposant sur la couche de base soit réalisée en TiO₂ et celle au contact de la couche terminale soit réalisée en Al₂O₃.

Dans des modes particuliers de réalisation, le substrat est formé par un corps réalisé en aluminium pur ou en alliage d'aluminium et comprenant la face support.

Dans des modes particuliers de réalisation, le substrat comprend un corps sur lequel est formé un revêtement réalisé en nitrure d'aluminium, en carbure d'aluminium, en oxyde d'aluminium ou en carbonitrure d'aluminium, le revêtement comprenant la face support.

Dans des modes particuliers de réalisation, l'empilement de couches minces diélectriques comporte quatre couches intermédiaires.

Dans des modes particuliers de réalisation, les couches de l'empilement de couches minces diélectriques présentent des épaisseurs choisies de sorte à conférer une couleur interférentielle au composant d'habillage caractérisée, dans l'espace CIELAB en mode réflexion de l'illuminant normalisé D65, avec un observateur de 10° et une géométrie de mesure di:8°, par les paramètres L* = [75 ; 85], a* = [-45 ; -35], b* = [5 ; 15].

Dans des modes particuliers de réalisation, la couche de base présente une épaisseur comprise entre 1 nm et 10 nm, les couches intermédiaires présentent une épaisseur comprise entre 20 nm et 90 nm et la couche terminale présente une épaisseur comprise entre 55 nm et 65 nm.

Dans des modes particuliers de réalisation, les couches intermédiaires prises successivement depuis la couche intermédiaire la plus proche de la couche de base jusqu'à la couche intermédiaire la plus proche de la couche terminale, présentent respectivement une épaisseur comprise entre 25 nm et 30 nm, entre 75 nm et 85 nm, entre 15 nm et 25 nm et entre 15 nm et 25 nm.

### Brève description des figures

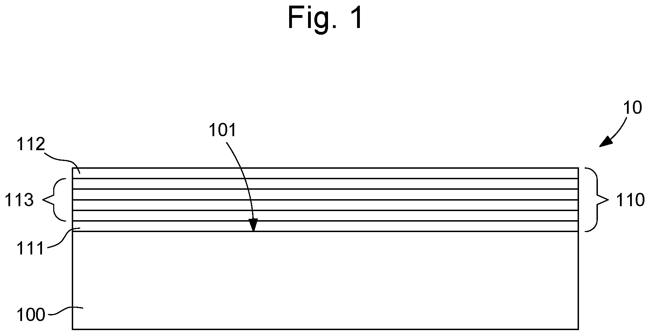

D'autres caractéristiques et avantages de l'invention apparaîtront à la lecture de la description détaillée suivante donnée à titre d'exemple nullement limitatif, en référence à la figure 1 qui représente schématiquement une vue de section d'un composant d'habillage respectivement selon un exemple préféré de réalisation de la présente invention.

On note que la figure n'est pas dessinée à l'échelle pour des raisons de clarté.

### Description détaillée de l'invention

La présente invention concerne un composant d'habillage 10 d'horlogerie, de bijouterie ou de joaillerie comprenant un substrat 100 présentant une face support 101 réalisée dans un matériau comprenant au moins 50% en masse d'aluminium.

Le composant d'habillage 10 selon l'invention est représenté schématiquement sur la figure 1 et est particulièrement adapté à former un cadran pour une pièce d'horlogerie, ou toute autre pièce préférentiellement interne de la pièce d'horlogerie, telle que des appliques ou des aiguilles.

Dans le présent texte, le matériau du substrat peut être de l'aluminium pur, un alliage d'aluminium, un nitrure d'aluminium, un carbure d'aluminium, un oxyde d'aluminium, etc.

Le substrat 100 est formé par un corps qui est, dans un exemple de réalisation de l'invention, réalisé dans le matériau comprenant au moins 50% en masse d'aluminium. La face support 101 est donc formée par une face du corps.

Dans d'autres exemples de réalisation de l'invention, le substrat 100 peut comprendre un corps sur lequel est réalisé un revêtement comprenant au moins 50% en masse d'aluminium. La face support 101 est donc formée par une face du revêtement.

Naturellement, la nature du matériau comprenant au moins 50% en masse d'aluminium détermine si la face support 101 est formée par le corps ou par le revêtement. Par exemple, si ce matériau est de l'aluminium pur ou un alliage d'aluminium, il peut constituer le corps du substrat 100. Si ce matériau est un nitrure d'aluminium, un carbure d'aluminium ou un carbonitrure d'aluminium, il peut constituer un revêtement déposé par des méthodes de dépôt adaptés, telles que les méthodes de dépôt physique en phase vapeur ou les méthodes de dépôt chimique en phase vapeur. Par ailleurs, si ce matériau est un oxyde d'aluminium, il peut constituer un revêtement réalisé par anodisation, de façon connue de l'homme du métier.

Le composant d'habillage 10 comporte sur sa face support 101, un empilement de couches minces diélectriques 110 semi-transparentes, c'est-à-dire au moins transparentes dans le domaine du visible. Les couches de l'empilement de couches minces diélectriques 110 sont chacune déposées par une méthode ALD. Chaque couche de l'empilement de couches minces diélectriques 110 présente une épaisseur comprise entre un nanomètre et quelques dizaines de nanomètres. Cette caractéristique permet à la fois de protéger la face support 101 du composant d'habillage 10 contre les agressions chimiques et environnementales, telle que l'humidité, et de la colorer par effet interférentiel précisément choisi et de façon répétable et robuste. Aussi, l'épaisseur de l'empilement de couches minces diélectriques 110 est homogène et conforme sur l'ensemble de sa surface.

La face support 101 peut présenter une structuration, par exemple réalisée par usinage mécanique, par exemple une gravure manuelle ou un usinage avec une machine-outil à commande numérique, par usinage chimique ou au laser. La structuration est formée par des creux et des sommets, la distance entre les creux et les sommets étant, par exemple, égale à au moins 1 µm, et son aspect est avantageusement préservé par l'empilement de couches minces diélectriques 110.

L'empilement de couches minces diélectriques 110 est formé par au moins deux couches minces diélectriques, dont une couche de base 111 reposant sur la face support 101, et une couche terminale 112. La couche de base 111 est avantageusement réalisée en Al₂O₃, et la couche terminale 112 est avantageusement réalisée en TiO₂.

La couche terminale 112 en TiO₂, en particulier, permet avantageusement de garantir la protection chimique du composant d'habillage.

Dans l'exemple de réalisation préféré de l'invention représenté sur la figure 1, l'empilement de couches minces diélectriques 110 comporte quatre couches intermédiaires 113 déposées entre la couche de base 111 et la couche terminale 112. Ces couches intermédiaires 113 sont réalisées alternativement en TiO₂ et en Al₂O₃, de sorte que la couche intermédiaire 113 reposant sur la couche de base 111 soit réalisée en TiO₂ et celle au contact de la couche terminale 112 soit réalisée en Al₂O₃.

Dans d'autres exemples de réalisation, l'empilement de couches minces diélectriques 110 peut comporter plus ou moins de quatre couches intermédiaires 113, pourvu qu'elles soient un nombre pair. Autrement dit, l'empilement de couches minces diélectriques 110 peut comporter au moins deux couches.

Avantageusement, la couche de base 111 présente une excellente affinité chimique avec la face support 101 sur laquelle elle est déposée, ce qui assure une très bonne accroche de la couche de base 111, et donc de l'empilement de couches minces diélectriques 110, et permet d'augmenter la vitesse de dépôt de la couche de base 111.

L'empilement de couches minces diélectriques 110 permet de conférer au composant d'habillage 10 une couleur interférentielle, dont la teinte dépend de l'épaisseur de chaque couche de l'empilement de couches minces diélectriques 110, de leur agencement et de leur nombre, et du matériau constituant la face support 101. Ainsi, la couleur interférentielle générée par les caractéristiques de l'invention est avantageusement très précise.

Dans l'exemple préféré de réalisation de l'invention, les couches de l'empilement de couches minces diélectriques 110 présentent des épaisseurs choisies de sorte à conférer une couleur interférentielle au composant d'habillage 10 caractérisée, dans l'espace CIELAB en mode réflexion de l'illuminant normalisé D65, avec un observateur de 10° et une géométrie de mesure di:8°, par les paramètres L* = [75 ; 85], a* = [-45 ; -35], b* = [5 ; 15], et plus précisément par les paramètres L* = 79, a* = -39, b* = 8.

Ainsi, dans cette première variante, le composant d'habillage 10 présente un aspect vert clair ou vert turquoise.

Dans cet exemple, chaque couche de l'empilement de couches minces diélectriques 110 présente une épaisseur comprise entre un et quelques dizaines de nanomètres, par exemple entre 1 nm et 90 nm. En particulier, la couche de base 111 présente une épaisseur comprise entre 1 nm et 10 nm, les couches intermédiaires 113 présentent une épaisseur comprise entre 20 nm et 90 nm et la couche terminale 112 présente une épaisseur comprise entre 55 nm et 65 nm. Plus précisément, les couches intermédiaires 113, prises successivement depuis la couche intermédiaire 113 la plus proche de la couche de base 111 jusqu'à la couche intermédiaire 113 la plus proche de la couche terminale 112, peuvent présenter respectivement les épaisseurs suivantes : entre 25 nm et 30 nm, entre 75 nm et 85 nm, entre 15 nm et 25 nm et entre 15 nm et 25 nm.

De manière plus générale, il est à noter que les modes de mise en oeuvre et de réalisation considérés ci-dessus ont été décrits à titre d'exemples non limitatifs, et que d'autres variantes sont par conséquent envisageables.

## Revendications

1. Composant d'habillage (10) d'horlogerie, de bijouterie ou de joaillerie, **caractérisé en ce qu'**il comprend un substrat (100) présentant une face support (101) réalisée dans un matériau comprenant au moins 50% en masse d'aluminium, sur laquelle est déposé un empilement de couches minces diélectriques (110) semi-transparentes comprenant au moins deux couches, dont une couche de base (111) réalisée en Al₂O₃ reposant sur la face support (101), et une couche terminale (112) réalisée en TiO₂.

2. Composant d'habillage (10) selon la revendication 1, comprenant un nombre pair de couches intermédiaires (113), et au moins deux, lesdites couches intermédiaires (113) étant déposées entre la couche de base (111) et la couche terminale (112) et étant alternativement réalisée en TiO₂ et en Al₂O₃ de sorte que la couche intermédiaire (113) reposant sur la couche de base (111) soit réalisée en TiO₂ et celle au contact de la couche terminale (112) soit réalisée en Al₂O₃.

3. Composant d'habillage (10) selon l'une des revendications 1 ou 2, dans lequel le substrat (100) est formé par un corps réalisé en aluminium pur ou en alliage d'aluminium et comprenant la face support (101).

4. Composant d'habillage (10) selon l'une des revendications 1 ou 2, dans lequel le substrat (100) comprend un corps sur lequel est formé un revêtement réalisé en nitrure d'aluminium, en carbure d'aluminium, en oxyde d'aluminium ou en carbonitrure d'aluminium, le revêtement comprenant la face support (101).

5. Composant d'habillage (10) selon la revendication 2, dans lequel l'empilement de couches minces diélectriques (110) comporte quatre couches intermédiaires (113).

6. Composant d'habillage (10) selon la revendication 5, dans lequel les couches de l'empilement de couches minces diélectriques (110) présentent des épaisseurs choisies de sorte à conférer une couleur interférentielle au composant d'habillage (10) caractérisée, dans l'espace CIELAB en mode réflexion de l'illuminant normalisé D65, avec un observateur de 10° et une géométrie de mesure di:8°, par les paramètres L* = [75 ; 85], a* = [-45 ; -35], b* = [5 ; 15].

7. Composant d'habillage (10) selon la revendication 6, dans lequel la couche de base (111) présente une épaisseur comprise entre 1 nm et 10nm, les couches intermédiaires (113) présentent une épaisseur comprise entre 20 nm et 90 nm et la couche terminale (112) présente une épaisseur comprise entre 55 nm et 65 nm.

8. Composant d'habillage (10) selon la revendication 7, dans lequel les couches intermédiaires (113) prises successivement depuis la couche intermédiaire (113) la plus proche de la couche de base (111) jusqu'à la couche intermédiaire (113) la plus proche de la couche terminale (112), présentent respectivement une épaisseur comprise entre 25 nm et 30 nm, entre 75 nm et 85 nm, entre 15 nm et 25 nm et entre 15 nm et 25 nm.
